# EUROPÄISCHE PATENTANMELDUNG

(11) **EP 1 601 023 A2**
(43) Veröffentlichungstag der Anmeldung: **30.11.2005**
(21) Anmeldenummer: 05008239.5
(22) Anmeldetag: 15.04.2005
(51) Int. Cl.: H01L 31/048, H01L 31/042, H01L 31/02

(54) **Solarzelle und Anordnung von einer Solarzelle und einer Leiterplatte**

(30) Priorität: 29.05.2004 DE 202004008593 U
(71) Anmelder: IXYS Semiconductor GmbH, D-68623 Lampertheim (DE)
(72) Erfinder: Strauch, Gerhard, Dr.rer.nat., 68642 Bürstadt (DE); Sperner, Andreas, Dipl.-Ing., 61462 Königstein/Ts. (DE)
(74) Vertreter: Oppermann, Frank

(57) **Zusammenfassung**

Die Erfindung beschreibt eine Solarzelle 10 mit einem transparenten Gehäuse 30 aus Kunststoff und aus dem Gehäuse herausragenden elektrischen Anschlüssen 50 zur Bestückung einer Leiterplatte 20, wobei die Solarzelle 10 als Bauelement mit Standardanschlüssen oder als oberflächenmontiertes Bauelement mit lötfähigen Anschlussflächen ausgebildet ist. Dadurch wir die flexible Anpassung von Solarzellen und deren Anordnungen, bestehend aus einer Vielzahl von in Reihe oder parallel geschalteter Solarzellen, an individuelle Solargeneratoren für ein breites Spektrum von Lösungen ermöglicht. Eine bevorzugte Ausführungsform der Solarzelle 10 verfügt am Gehäuse über Mittel 80 zur formschlüssigen Verbindung von Solarzellen, wie z.B. Federn und Nuten. Durch die mechanische Fixierung der Solarzellen, können die Solarzellen 10 zu größeren Einheiten vor der Bestückung der Leiterplatte 20 zusammengesetzt werden. Die Vorkonfiguration der Solarzellen 10 verleiht der Solarzellenanordnung Formstabilität und verbessert den Montage- und Lötvorgang.

## Beschreibung

Die Erfindung betrifft Solarzellen, die in der Photovoltaik zur Umwandlung von kurzwelliger elektromagnetischer Strahlungsenergie in elektrische Energie unter Ausnutzung des photovoltaischen Effektes verwendet werden. Solarzellen werden zu einem Modul, bestehend aus einer Anordnung von auf ein Trägersubstrat in Reihe oder parallel geschalteten Solarzellen, zusammengestellt. Eine Serienschaltung der Solarzellen hat eine höhere Spannung zur Folge, eine Parallelschaltung einen höheren Strom.

Bekannt sind bislang Solarzellenanordnungen auf PCB Basis, wobei die Solarzellen auf Leiterplatten, bestehend aus Kunststoff oder aus Epoxydharz getränkten Glasfasern, aufgebracht sind. Letztere Leiterplatten sind heute vorwiegend üblich und stellen das am häufigsten eingesetzte Leiterplattenmaterial dar. Die Bezeichnung PCB ist die in der Elektronik gebräuchliche Abkürzung für Printed Circuit Board.

Solarzellen werden üblicherweise nach dem Stand der Technik auf Substrate, z.B. die zuvor genannten Leiterplatten oder DCB-Substrate (**D**irect **C**opper **B**onding) geklebt oder gelötet, und z.B. mit sogenannten Bonddrähten oder Lötverbindungen elektrisch kontaktiert. Man spricht in diesem Zusammenhang auch von externer Verdrahtung bzw. Verbindung von Solarzellen.

Im Gegensatz dazu werden konventionelle Bauelemente, wie z.B. Widerstände oder Kondensatoren, auf Leiterplatten aufgebracht und mit den Leiterbahnen verlötet. Dazu werden die Bauelemente entweder mittels Durchsteckmontage oder Oberflächenmontage (SMT; **S**urface **M**ounted **T**echnology) auf Leiterplatten montiert. Oberflächenmontierte Bauelemente werden auch SMD-Bauelemente genannt. Der aus der Elektronik bekannte Fachbegriff **SMD** ist die in der Elektronik gebräuchliche Abkürzung für **S**urface **M**ounted **D**evice.

Zur Anbindung des Solarmoduls an die Peripherie werden dessen elektrischen Anschlüsse (Plus- und Minuspol) nach außen geführt. Zudem werden die Solarzellen mit einem transparenten Kunststoff zum Schutz gegen Umwelteinflüsse (Staub, Feuchtigkeit, etc.) vergossen.

Nachteilig an derartigen nach dem Stand der Technik ausgebildeten Solarmodulen ist, dass durch die festen geometrischen Abmessungen die elektrischen Ausgangsspannungswerte, Stromwerte und damit auch die Leistungswerte standardmäßig festgelegt sind. Dadurch wir die Anpassung an individuelle Solargeneratoren erschwert. Abweichungen von diesem Standard zum Zwecke individueller Solarzellenanordnungen für individuelle Lösungen rechnen sich nach dem Stand der Technik erst ab einer Mindestlosgröße.

Der Erfindung liegt daher die Aufgabe zugrunde, Solarzellen, durch die flexible Gestaltung der Solarzellenanordnung von Solarmodulen, individuellen Anwendungen zugänglich zu machen, und für die unterschiedlichen Anwendungsbereiche geeignete Spannungen und Ströme bereitzustellen.

Die Aufgabe wird erfindungsgemäß durch eine Solarzelle mit einem transparenten Gehäuse aus Kunststoff und aus dem Gehäuse herausragenden elektrischen Anschlüssen zur Bestückung einer Leiterplatte gelöst, wobei die Solarzelle als Bauelement mit Standardanschlüssen oder als oberflächenmontiertes Bauelement mit lötfähigen Anschlussflächen ausgebildet ist.

In Analogie zu konventionellen Bauelementen, wie z.B. Widerständen oder Kondensatoren, können die erfindungsgemäßen Solarzellen auf Leitplatten mit den Leiterbahnen verlötet werden, um den flexiblen Einsatz von Solarzellen zu ermöglichen. Die zuvor beschriebene äußere Verdrahtung der Solarzellen entfällt dadurch.

Bei der Anbringung der Solarzellen mittels Durchsteckmontage werden die Anschlussdrähte der Solarzelle, durch Bestückungslöcher geführt und auf der Rückseite der Leiterplatte verlötet. Dagegen werden bei der Oberflächenmontage die Solarzellen mittels lotfähiger Anschlussflächen direkt an der Unterseite auf die Oberfläche der Leiterplatte montiert und verlötet.

In beiden Fällen wird die nach dem Stand der Technik vorliegende externe Verbindung der Solarzellen mittels Bonddrähten oder Lötbändern durch die interne Verbindung mittels auf der Leitplatte liegender Leiterbahnen ersetzt.

Durch die erfindungsgemäße Ausbildung einer Solarzelle mit elektrischen Standardanschlüssen oder als SMD-Bauelement zur Bestückung einer Leiterplatte wird die flexible Gestaltung von Solarmodulen, bestehend aus einer Vielzahl von in Reihe oder parallel geschalteten Solarzellen, überhaupt erst ermöglicht. Die individuelle Zusammenstellung von Solarzellen auf Leiterplatten zu Solarmodulen erlaubt die Abdeckung eines großen Anwendungsspektrums ohne der Forderung nach größeren Losgrößen nachkommen zu müssen.

Im Gegensatz zu Solarzellen sind Leiterplatten in verschiedenen Ausführungen und Abmessungen kostengünstig erhältlich.

Ein weiterer besonderer Vorteil der relativ kleinen Abmessungen der erfindungsgemäß ausgebildeten Solarzellen liegt darin begründet, dass sich bis zu einem gewissen Grad auch runde und wellenförmige Oberflächen mit flexiblen Leiterbahnen bestücken lassen.

In einer bevorzugten erfindungsgemäßen Ausführungsform ist die Solarzelle am Gehäuse mit Mitteln zur formschlüssigen Verbindung mit anderen Solarzellen versehen.

Derartige am Gehäuse der Solarzellen angebrachte Mittel zur formschlüssigen Verbindung ermöglichen die Vorkonfiguration der Solarzellen vor der Montage auf die Leiterplatte. Sie erhöhen zudem die Festigkeit der Solarzellenanordnung, aufweisend eine Vielzahl von in Reihen oder parallelgeschalteten Solarzellen. Darüber hinaus verleiht die mechanische Fixierung der Solarzellenanordnung Formstabilität, die den negativen Effekt des Wegschwimmens von auf Leiterplatten gelöteten Solarzellen während des Lötvorgangs unterbindet. Sowohl der Montagevorgang als auch Lötvorgang werden dadurch erleichtert.

Als Mittel zur formschlüssigen Verbindung von Solarzellen können beispielsweise Nuten und/oder Federn am Gehäuse der Solarzelle vorgesehen sein. Zur Verbindung von Solarzellen sind aber auch andere bekannte formschlüssige Verbindungen der Verbindungstechnik möglich.

In einer bevorzugten Ausführungsform der Erfindung ist der die Solarzellen abdeckende transparente Kunststoff zur Leistungssteigerung und Wirkungsgradsteigerung des Solarmoduls mit optischen Hilfsmitteln, insbesondere Linsenstrukturen, versehen, durch die das einfallende Licht um ein Vielfaches entsprechend des Konzentrator-Effektes verstärkt wird. Beispielsweise sind Fresnel-Linsen besonders vorteilhaft, da die Brennweite kurz und das Volumen durch Aufteilung in ringförmige Bereiche, auch Fresnel-Zonen genannt, gegenüber herkömmlichen Linsen mit gleichem Durchmesser und Brennweite klein ist.

Im folgenden werden Ausführungsbeispiele der Erfindung anhand von Zeichnungen näher beschrieben. Es zeigen in stark schematisierter Darstellung:
- Fig. 1: Anordnung I von Solarzellen 10 und einer Leiterplatte 20 in der klassischen Form mittels Dursteckmontage, dargestellt in der Seitenansicht,
- Fig. 2: Anordnung I von Solarzellen 10 und einer Leiterplatte 20 in der klassischen Form mittels Dursteckmontage, dargestellt in der Draufsicht,
- Fig. 3: Anordnung II von Solarzellen 10 und einer Leiterplatte 20 mittels Oberflächenmontage, dargestellt in der Seitenansicht,
- Fig. 4: Anordnung II von Solarzellen 10 und einer Leiterplatte 20 mittels Oberflächenmontage, dargestellt in der Draufsicht.

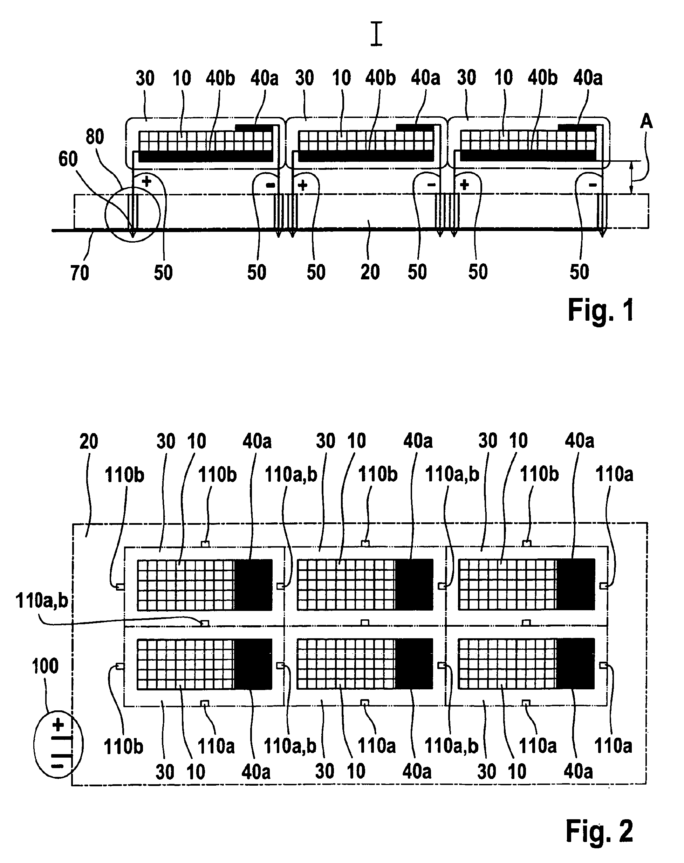

Fig. 1 zeigt die prinzipielle Anordnung I von Solarzellen 10 und einer Leiterplatte 20 in der Seitenansicht, wobei die Solarzellen 10 analog zu konventionellen Bauteilen in der klassischen Form mit der Leiterplatte 20 verlötet sind. Die Solarzelle 10 weist an ihrer Oberseite einen Frontkontakt 40a für den Minuspol und an der Unterseite einen Rückkontakt 40b für den Pluspol auf. Zudem ist die Solarzelle 10 von einem transparenten Kunststoffgehäuse 30 umgeben, aus dem die Anschlussdrähte 50 zur Bestückung der Leiterplatte herausragen, wobei die der Leiterplatte zugewandte Gehäuseseite nicht zwingend transparent ausgebildet sein muss. Die Anschlussdrähte 50, auch Standard-Leads genannt, sind bei der klassischen Durchsteckmontage durch die Bestückungslöcher 80 geführt und auf der Rückseite der Leiterplatte an den Lötstellen 60 mit den Leiterbahnen 70 verlötet. Wie für die klassische Bestückung einer Leiterplatte 20 üblich, sind die Leiterbahnen 70 an der Unterseite der Leiterplatte 20 angebracht. Die Solarzellen liegen nicht auf der Leiterplatte auf. Der mit A bezeichnete Abstand zwischen der Leiterplatte und den Solarzellen beträgt üblicherweise 50 bis 150µm.

Fig. 2 zeigt die prinzipielle Anordnung I von Solarzellen 10 und einer Leiterplatte 20 in der Draufsicht, aufweisend mehrere miteinander verbundene Solarzellen, wobei die Solarzellen am Gehäuse mittel 110 zur formschlüssigen Verbindung der Solarzellen aufweisen. Diese Mittel zur formschlüssigen Verbindung können z.B. Feder und Nuten sein. Die elektrischen Anschlüsse 100 der Leiterplatte sind zur Anbindung der Solarzellenanordnung an die Peripherie nach außen geführt.

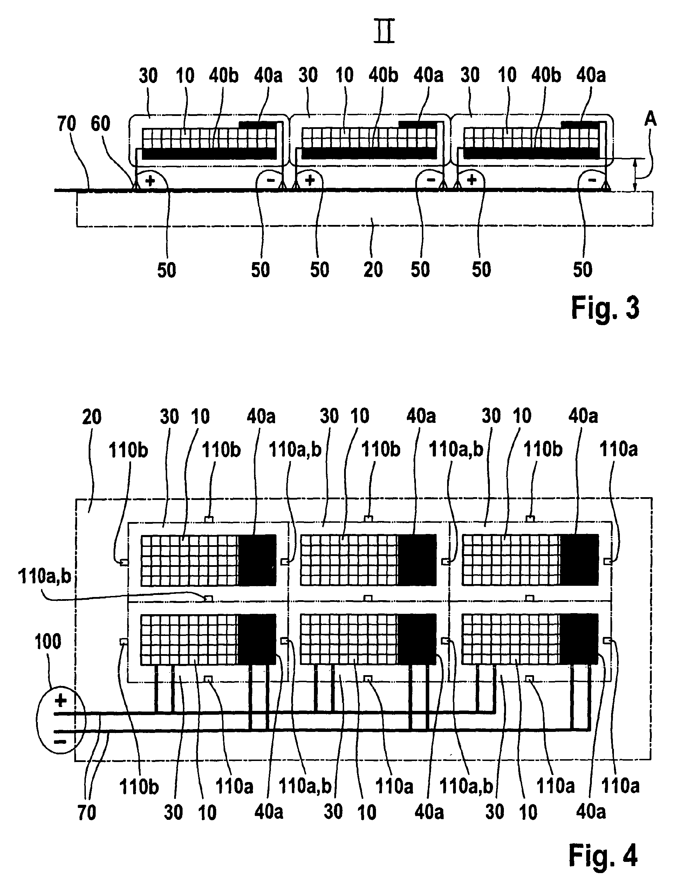

Fig. 3 zeigt die prinzipielle Anordnung II von Solarzellen 10 und einer Leiterplatte 20 in der Seitenansicht, wobei die Solarzellen 10 analog zu oberflächenmontierten Bauteilen, auch SMD Bauteile genannt, mit lotfähigen Anschlussflächen aus Kupfer (Cu) an den Lötstellen 60 mit der Leiterplatte 20 verlötet sind. Wie für Bestückung einer Leiterplatte 20 mit SMD-Bauteilen üblich, sind die Leiterbahnen 70 an der Oberseite der Leiterplatte 20 angebracht. Die Solarzellen liegen nicht auf der Leiterplatte auf. Der mit A bezeichnete Abstand zwischen der Leiterplatte und den Solarzellen beträgt üblicherweise 50 bis 100µm.

Fig. 4 zeigt die prinzipielle Anordnung II von Solarzellen 10 und einer Leiterplatte 20 in der Draufsicht, aufweisend mehrere miteinander verbundene Solarzellen, wobei die Solarzellen am Gehäuse Mittel 110 zur formschlüssigen Verbindung der Solarzellen aufweisen. Diese Mittel zur formschlüssigen Verbindung können z.B. Federn und Nuten sein. Im Gegensatz zu Fig. 2 weist die Oberfläche der Leiterplatte 20 die Leiterbahnen 70 auf. Die elektrischen Anschlüsse 100 der Leiterplatte sind zur Anbindung der Solarzellenanordnung an die Peripherie nach außen geführt.

## Patentansprüche

1. Solarzelle mit einem transparenten Gehäuse (30) aus Kunststoff und aus dem Gehäuse herausragenden elektrischen Anschlüssen (50) zur Bestückung einer Leiterplatte (20), **dadurch gekennzeichnet, dass** die Solarzelle als Bauelement mit Standardanschlüssen oder als oberflächenmontiertes Bauelement mit lötfähigen Anschlussflächen ausgebildet ist.

2. Solarzelle nach Anspruch 1, **dadurch gekennzeichnet, dass** das Gehäuse (30) Mittel (110a, 110b) zur formschlüssigen Verbindung mit anderen Solarzellen aufweist.

3. Solarzelle nach Anspruch 2, **dadurch gekennzeichnet, dass** Nuten (110a) und/oder Federn (110b) am Gehäuse der Solarzelle als Mittel (110a, 110b) für die formschlüssige Verbindung von Solarzellen vorgesehen sind.

4. Solarzelle nach einem der Ansprüche 1 bis 3, **dadurch gekennzeichnet, dass** der die Solarzellen (10) abdeckende transparente Kunststoff (30) zur Leistungssteigerung und Wirkungsgradsteigerung des Solarmoduls mit optischen Hilfsmitteln, insbesondere Linsenstrukturen, versehen ist, durch die das einfallende Licht um ein Vielfaches verstärkt wird.

5. Anordnung von mindestens einer Solarzelle (10) nach einem der Ansprüche 1 bis 4 und einer Leiterplatte (20), wobei die Solarzelle (10) an der Unterseite mit lötfähigen Anschlussflächen direkt auf die Leiterplatte (20) gelötet ist.

6. Anordnung von mindestens einer Solarzelle (10) nach einem der Ansprüche 1 bis 4 und einer Leiterplatte (20), wobei die Anschlussdrähte (50) der Solarzelle (10) durch Bestückungslöcher (80) der Leiterplatte (20) geführt und auf der Rückseite der Leiterplatte (20) verlötet sind.
